# EUROPÄISCHE PATENTSCHRIFT

(11) **EP 0 586 947 B1**
(45) Veröffentlichungstag und Bekanntmachung des Hinweises auf die Patenterteilung: **02.01.1997**
(21) Anmeldenummer: 93113277.3
(22) Anmeldetag: 19.08.1993
(51) Int. Cl.: G01R 33/28, F17C 13/00

(54) **Kryostat mit mechanisch flexibler thermischer Kontaktierung**
Cryostat with a flexible mechanical way of making thermal contact
Cryostat pourvu de moyen mécanique flexible de contact thermique

(30) Priorität: 19.08.1992 DE 4227388
(43) Veröffentlichungstag der Anmeldung: 16.03.1994
(73) Patentinhaber: Spectrospin AG, CH-8117 Fällanden (CH)
(72) Erfinder: Janssen, Volker, CH-8135 Langnau a/A (CH)
(74) Vertreter: KOHLER SCHMID + PARTNER

(56) Entgegenhaltungen:
- DE-A- 2 906 060
- US-A- 2 516 583

## Beschreibung

Die Erfindung betrifft einen Kryostat zur Aufnahme einer supraleitenden Magnetspule, beispielsweise für Kernspinresonanz (NMR) - oder Ionenzyklotronresonanz (ICR)-Messungen, mit einem Zentralbehälter für eine kryogene Flüssigkeit, insbesondere flüssiges Helium, der durch Befestigungsmittel, vorzugsweise dünnwandige Aufhängungsrohre, mit der Innenseite eines geschlossenen Außenmantels des Kryostaten mechanisch verbunden, vorzugsweise daran angehängt ist, wobei die Befestigungsmittel über thermisch gut leitfähige, rohrförmige Verbindungselemente, die die Befestigungsmittel allseitig umgeben, in gutem thermischen Kontakt mit einer den Zentralbehälter umgebenden Schale stehen, die auf der Temperatur einer zweiten kryogenen Flüssigkeit, insbesondere flüssigen Stickstoffs, deren Siedepunkt höher als der Siedepunkt der Flüssigkeit im Zentralbehälter liegt, gehalten wird.

Ein solcher Kryostat ist beispielsweise aus der DE-A-29 06 060 bekannt.

Beim Bau von Kryostaten kommt es häufig vor, daß eine thermische Kontaktierung benötigt wird, welche auf die übrigen Konstruktionsteile möglichst geringe mechanische Kräfte ausüben darf. Beispielsweise ist es üblich, bei einem Kryostaten für NMR-Magnete die den flüssigen Stickstoff enthaltende Schale an drei dünnwandigen Stahlrohren, die gleichmäßig über den Umfang verteilt sind, aufzuhängen und an der Innenseite des Außenmantels des Kryostaten zu befestigen. Eine solche Aufhängung ist statisch definiert und führt zu keinen besonderen Problemen. Zusätzlich muß aber die Forderung erfüllt werden, daß das Stickstoffgefäß thermisch mit den beiden dünnwandigen Stahlrohren der Aufhängung des flüssiges Helium enthaltenden Zentralbehälters kontaktiert werden muß, um eine bessere thermische Trennung des Helium-Behälters von der im Außenraum des Kryostaten herrschenden Temperatur (ca. 300 K) zu erreichen.

Die Kontaktelemente zwischen der Aufhängung des Heliumbehälters und der ihn umgebenden Schale mit flüssigem Stickstoff werden bisher normalerweise relativ starr ausgeführt. In der oben genannten Druckschrift sind die Aufhängungsrohre, die gleichzeitig als Lüftungs- und Füllrohre für den Helium-Behälter dienen, über starre Wärmeübergangskragen aus Aluminium mit allseits geschlossenen, thermisch leitfähigen und zu den Aufhängungsrohren koaxialen Verbindungsrohren verbunden, die an ihrem anderen Ende mit dem Behälter für flüssigen Stickstoff in thermischem Kontakt stehen und sich daher im wesentlichen auf der Temperatur des flüssigen Stickstoffs befinden.

Diese mechanisch starre thermische Kontaktierung kann bei Abkühlung des Kryostaten auf die Temperatur des flüssigen Stickstoffs bzw. des flüssigen Heliums aufgrund der dabei auftretenden thermisch verursachten Spannungen, welche durch die noch vorhandene Elastizität der mechanischen Konstruktion aufgenommen werden müssen, zu einem statisch undefinierten mechanischen Zustand führen.

Solange das Gefäß mit dem flüssigen Stickstoff symmetrisch aufgebaut ist und die Aufhängungen (in der Regel drei) gleichmäßig abgekühlt werden, kann sich das Stickstoffgefäß nur in Richtung der Aufhängungen, also nach oben oder unten verschieben. Es treten daher keine seitlichen Verschiebungen und damit auch keine Störungen der vorhandenen Axialsymmetrie des Kryostatenaufbaus auf. Dies hat zur Folge, daß die beiden Verbindungsanordnungen zwischen dem Flüssigstickstoffgefäß und den thermischen Kontaktierungen an den beiden Stahlrohraufhängungen nur Kräfte in vertikaler Richtung, die annähernd gleich groß sind, auf die beiden Stahlrohre der Aufhängung des Heliumgefäßes übertragen können. Das Heliumgefäß kann sich somit nur in vertikaler Richtung verschieben, und dies auch nur geringfügig infolge der in dieser Richtung äußerst großen mechanischen Festigkeit der beiden Stahlrohre. Dieser Fall ist deshalb im allgemeinen unkritisch.

Anders verhält es sich, wenn die drei Aufhängungsrohre des Stickstoffbehälters nicht gleichmäßig abgekühlt werden. In diesem Fall verändern sich die Längen der drei Aufhängungen unterschiedlich und der Stickstoffbehälter erfährt eine seitliche Verschiebung, welche über die beiden Verbindungsanordnungen zu den thermischen Kontaktierungen auf das Heliumgefäß übertragen wird. Die beiden Aufhängungsrohre des Heliumgefäßes können dieser seitlichen Verschiebung keine genügend große Kraft entgegenbringen, so daß das Heliumgefäß nahezu dieselbe seitliche Verschiebung wie der Stickstoffbehälter erfährt. Mit dem Heliumgefäß verschiebt sich aber auch das Zentrum der darin angeordneten Kryomagnetspule in Bezug auf die ruhende Meßprobe innerhalb der zentralen Raumtemperaturbohrung des Kryostaten. Die Meßprobe erfährt damit eine Feldänderung, die das NMR-Spektrum nachteilig beeinflußt und zumindest ein neues "Shimen" des Feldes notwendig macht. Störend kommt noch hinzu, daß dieser Vorgang zusätzlich von der Höhe des Pegels des flüssigen Stickstoffs abhängt, genauer gesagt vom aktuellen Gewicht dieser Flüssigkeit.

Die Aufhängungsrohre des Flüssigstickstoffbehälters können normalerweise nicht gleichmäßig abgekühlt werden, weil eines der Rohre ständig aus Sicherheitsgründen mit einem Überdruckventil versehen sein muß. Durch dieses Rohr kann daher kein kaltes Stickstoffgas abdampfen, so daß es nach einiger Zeit deutlich wärmer als die beiden anderen Rohre ist. Damit kommt es in der Regel zu den oben beschriebenen Querverschiebungen des zentralen Heliumbehälters relativ zur Raumtemperaturbohrung des Kryostaten.

Wegen der Symmetrie und der Stärke der stählernen Aufhängungsrohre in vertikaler Richtung bestand in der Fachwelt bisher die Meinung, daß es bei Abkühlung des Kryostaten zu keinen Geometrieverschiebungen kommen könne. Aufgabe der Erfindung ist es demgegenüber, einen Kryostaten herkömmlicher Art mit möglichst einfachen Mitteln so zu modifizieren, daß die oben geschilderte horizontale Verschiebung des den Kryomagneten enthaltenden Zentralbehälters bei Abkühlung des Kryostaten aufgrund einer Verkippung der den Zentralbehälter umgebenden, mit einer zweiten kryogenen Flüssigkeit gefüllten Schale, die sich auf den Zentralbehälter überträgt, vermieden wird.

Diese Aufgabe wird erfindungsgemäß durch ebenso verblüffend einfache, wie wirkungsvolle und kostengünstig durchzuführende Art und Weise dadurch gelöst, daß die thermisch gut leitfähigen, rohrförmigen Verbindungselemente mechanisch flexibel gestaltet sind. Das oben geschilderte und von der Fachwelt bisher nicht richtig erkannte Problem liegt nämlich nicht in der mechanischen Festigkeit und Zuverlässigkeit der Verbindungselemente, die auch bisher schon gewährleistet war, sondern in der Übertragung mechanischer Kräfte vom Flüssigstickstoffbehälter über die bisher bekannten starren Verbindungselemente auf den zentralen Heliumbehälter. Dieses Problem wird durch die mechanisch flexible Ausgestaltung der erfindungsgemäßen Verbindungselemente elegant umgangen. Im Gegensatz zu den Aufhängungsrohren und der Ankopplung von Zwischenstrahlungsschilden muß nämlich die thermische Verbindung zwischen dem Flüssigstickstoffbehälter und dem Heliumabdampfrohr außer ihrem eigenen Gewicht nichts tragen.

Bei einer bevorzugten Ausführungsform sind die Verbindungselemente Rohre aus einem thermisch gut leitfähigen Metall, beispielsweise aus Kupfer, mit vorzugsweise zylindrischem Querschnitt, die am Umfang mit Schlitzen versehen sind. Dies hat den Vorteil, daß die Verbindungselemente gleichzeitig als Strahlungsschilde wirken, die das Abdampfrohr von der Kontaktstelle abwärts allseitig umschließen und höhere Temperaturen als die Temperatur des flüssigen Stickstoffs, auf der sie sich selbst aufgrund ihrer thermischen Verbindung mit dem Stickstoffbehälter befinden, von dem Heliumabdampfrohr abhalten.

Bei einer besonders bevorzugten Weiterbildung dieser Ausführungsform sind die Schlitze spiralwendelförmig am Umfang der Rohre vorgesehen. Ausgehend von einer zylinderförmigen Rohranordnung, die bereits durch ihre geometrische Form bestens an die in der Regel zylinderförmige Kontaktierungsfläche am Heliumabdampfrohr angepaßt ist, wird durch eine spiralförmige Aussparung am Umfang, die ohne weiteres leicht in ein zylinderförmiges Rohr eingefräßt werden kann, eine Federwirkung hervorgerufen, welche die Übertragung von horizontalen wie auch vertikalen Kräften sehr stark vermindert. Der thermische Widerstand derartiger Verbindungselemente wird zwar durch den spiralförmigen Einschnitt ein wenig erhöht. Dies ist aber ohne größere Bedeutung, da dieser thermische Widerstand ohnehin schon wesentlich kleiner ist als der thermische Widerstand der Kontaktierung selbst. Die Form der Verbindungselemente läßt sich bei dieser Ausführungsform einfach und kostengünstig aus einem zylinderförmigen Rohr ( beispielsweise aus Kupfer) herstellen, welches durch die spezielle Verformungstechnik des Drückens in die gewünschte Form gebracht wird.

Bei einer anderen, ebenfalls sehr einfachen, kostengünstig herzustellenden Ausführungsform sind die Schlitze im wesentlichen parallel zur Längsachse der Rohre vorgesehen. Durch diese Längsschlitze werden die Rohre in horizontaler Richtung quer zu ihrer Längsachse nachgiebig.

Bei einer Weiterbildung dieser Ausführungsform weisen die Schlitze mindestens eine der halben axialen Erstreckung der Rohre entsprechende Länge auf. Durch die langen Schlitze wird eine besonders hohe Verformbarkeit und Flexibilität der Verbindungselemente in einer Richtung quer zur Achse erzielt.

Ein Nachteil dieser Ausführungsform besteht jedoch darin, daß durch die große axiale Erstreckung der Schlitze der thermische Widerstand der Verbindungselemente stark erhöht und ihre Abschirmfähigkeit als Strahlungsschilde erniedrigt wird. Diese Nachteile werden bei einer Ausführungsform vermieden, bei der die Schlitze eine im Verhältnis zur axialen Erstreckung der Rohre geringe Länge aufweisen.

Damit der dadurch eingehandelte Verlust an Flexibilität der Rohre wieder wettgemacht wird, sind bei einer Weiterbildung dieser Ausführungsform sowohl in Umfangsrichtung nebeneinander als auch in axialer Richtung übereinander eine Vielzahl von Schlitzen vorgesehen.

Um Flexibilität auch in axialer Richtung zu erreichen, können bei Ausführungsformen der Erfindung auch Schlitze in einer Richtung quer zur Längsachse der Rohre vorgesehen sein.

Eine Verbindung der Vorteile und Nachteile der oben geschilderten Ausführungsformen ergibt sich bei einer weiteren Ausführungsform, bei der kreuzförmige und/oder X-förmige Schlitze vorgesehen sind.

Eine andere Möglichkeit der flexiblen Gestaltung der rohrförmigen Verbindungselemente besteht darin, daß sie flexible Bänder, insbesondere zu Bändern geflochtene Filamente, beispielsweise Kupferfilamente aufweisen. Diese weichen Bandstrukturen können sich bei einer Verschiebung des Flüssigstickstoffbehälters in irgendeine Richtung ohne weiteres nach außen bauschen.

Bei einer Ausführungsform der Erfindung sind die rohrförmigen Verbindungselemente nur in einem bestimmten Bereich ihrer axialen Länge flexibel, vorzugsweise im mittleren Bereich zwischen den Rohrenden. Dadurch können die Kontaktstellen der Verbindungselemente mit den Befestigungsmitteln bzw. mit der den Zentralbehälter umgebenden Schale zum Zwecke eines guten Wärmeüberganges starr und eng anliegend gestaltet werden, ohne die Flexibilität der Verbindungselemente einzuschränken, so daß sie insbesondere immer noch ihre erfindungsgemäße Aufgabe erfüllen, nämlich die Bewegungen der äußeren Schale mechanisch von den Befestigungsmitteln des Zentralbehälters abzukoppeln.

Bevorzugt ist eine Ausführungsform, bei der die rohrförmigen Verbindungselemente auf ihrer axialen Länge unterschiedliche Durchmesser aufweisen. Dadurch können die Verbindungselemente einerseits an die Form und den Verlauf der Befestigungsmittel, andererseits an die Geometrie der den Zentralbehälter umgebenden Schale angepaßt werden.

Bei einer besonders bevorzugten Weiterbildung dieser Ausbildungsform weisen die rohrförmigen Verbindungselemente an dem Ende, an dem sie mit dem Befestigungsmittel in thermischem Kontakt stehen, einen engen Querschnitt auf, während sie in axialen Abstand von der Kontaktstelle radial weiter sind. Auf diese Weise kann die Funktion der Verbindungselemente als Zwischenstrahlungsschilde sichergestellt werden.

Diesem Ziel dient auch eine Ausführungsform, bei der die rohrförmigen Verbindungselemente an der Kontaktstelle mit den Verbindungsmitteln einen starren, die Verbindungsmittel eng umschließenden ringförmigen Kragen aufweisen, der vorzugsweise aus Kupfer oder Aluminium besteht, und an den die übrigen Teile der Verbindungselemente, insbesondere der flexible Teil, thermisch gut leitend angeschlossen sind. Mit dieser Ausführungsform kann insbesondere ein besonders guter Wärmeübergang zwischen den Verbindungselementen und den Befestigungsmitteln bewirkt werden.

Ihre Zusatzaufgabe als Zwischenstrahlungsschilde können die erfindungsgemäßen rohrförmigen Verbindungselemente schließlich bei einer Ausführungsform besonders gut erfüllen, bei der sie die Befestigungsmittel außerhalb der Kontaktstelle über eine axiale Länge in Richtung von der Kontaktstelle zum Zentralbehälter berührungsfrei vollständig umgeben.

Die Erfindung wird im Folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln, für sich oder zu mehreren in beliebiger Kombination Anwendung finden. Es zeigen:
- Fig. 1a: einen Ausschnitt aus einem schematischen Vertikalschnitt durch einen erfindungsgemäßen Kryostaten;
- Fig. 1b: ein erfindungsgemäßes Verbindungselement mit einem spiralwendelförmigen Schlitz am Umfang;
- Fig. 2: eine schematische, teilweise geschlossene Vertikalschnittansicht eines Kryostaten für NMR-Magnete nach dem Stand der Technik; und
- Fig. 3a-g: schematische Darstellungen von Schlitzgeometrien der erfindungsgemäßen Verbindungselement.

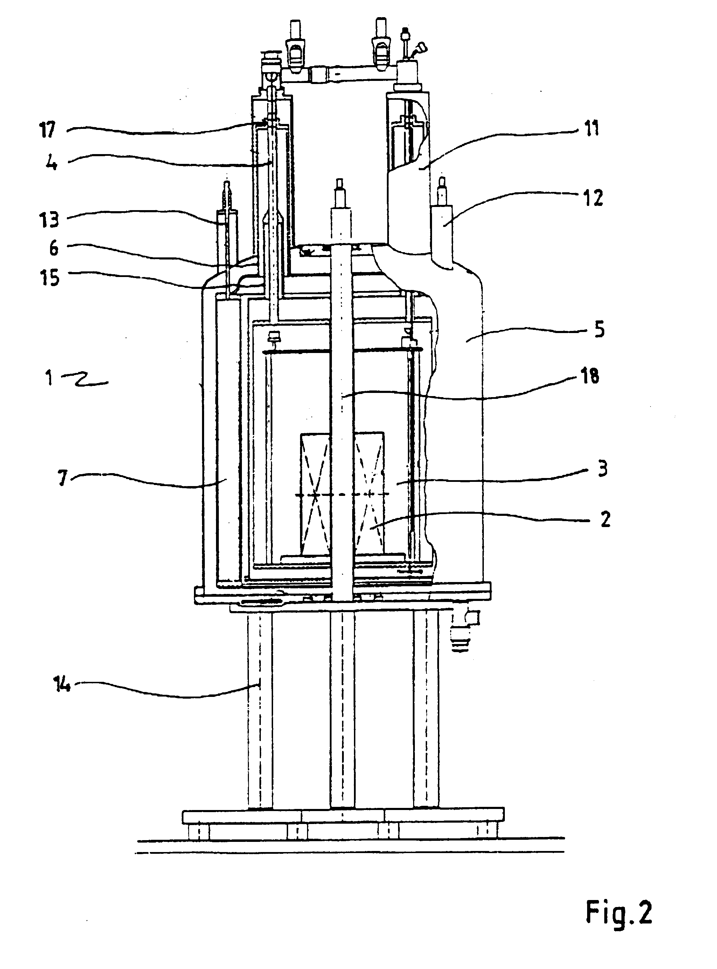

Der in Fig. 2 gezeigte Kryostat 1 nach dem Stand der Technik eignet sich insbesondere für die Aufnahme einer supraleitenden Magnetspule 2 für Kernspinresonanz (NMR)-Messungen. Er steht auf einem dreibeinigen Gestell 14 und ist umgeben von einem metallischen Außenmantel 5. Die supraleitende Magnetspule 2 ist in einem Zentralbehälter 3 gelagert, der mit flüssigem Helium zur Kühlung der Magnetspule 2 gefüllt ist.

Um eine möglichst geringe thermische Berührung mit der Außenwelt zu erreichen, ist der Zentralbehälter 3 über Befestigungsmittel 4, die gleichzeitig als Zuleitungs- und Abdampfrohre für das flüssige Helium dienen, an der Innenseite des Außenmantels 5 aufgehängt. Auf dem Weg durch das Abdampfrohr 4 gibt das aus dem Zentralbehälter 3 abdampfende Helium seine restliche Enthalphie über die Rohrwand zunächst an einen thermisch gut leitend daran angeschlossenen Strahlungsschild 15 ab, der auf einer Temperatur zwischen dem Siedepunkt von Helium und dem Siedepunkt von Stickstoff liegt. Bei seinem weiteren Weg durch den im Außenmantel 5 gebildeten Heliumabdampfturm 11, der das Abdampfrohr 4 allseitig umgibt, erreicht das abdampfende Helium eine in der Nähe der Oberseite des Turmes 11 vorgesehene Kontaktstelle 17, die über ein Verbindungselement 6, das nach dem stand der Technik als ein das Heliumabdampfrohr 4 umgebendes starres Rohr ausgeführt ist und mit einem den Zentralbehälter 3 schalenförmig umgebenden Behälter 7 mit flüssigem Stickstoff in thermischem Kontakt steht. An der Kontaktstelle 17 hat daher das Abdampfrohr 4 und das darin abdampfende Helium ungefähr die Siedetemperatur von flüssigem Stickstoff.

Das Verbindungselement 6 wirkt dabei für den unteren Teil des von ihm ummantelten Heliumabdampfrohres 4 als Strahlungsschild, der höhere Temperaturen als die Temperatur flüssigen Stickstoffs vom größten Teil des Heliumabdampfrohres 4 fernhält. Im letzten kurzen Wegstück bis zur Aufhängung des Heliumabdampfrohres 4 im Heliumabdampfturm 11 schließlich erwärmt sich das abdampfende Helium von der Temperatur flüssigen Stickstoffs bis ungefähr auf Zimmertemperatur der den Kryostaten 1 umgebenden Atmosphäre und gibt dabei seine restliche Enthalphie über die Außenwand des Heliumabdampfrohres 4 hauptsächlich an die Innenseite des Außenmantels 5 und teilweise auch an die umgebende Luft ab.

Ähnlich wie der Zentralbehälter 3 ist auch der schalenförmige Flüssigstickstoffbehälter 7 über Stahlrohre 13, die von Stickstoffabdampftürmen 12 im Außenmantel 5 umgeben sind, am Außenmantel 5 aufgehängt. Üblicherweise sind die bekannten Kryostaten 1 für NMR-Magente mit drei Stickstoffabdampftürmen 12 und zwei Heliumabdampftürmen 11 ausgestattet.

Moderne Kryostaten 1 dieser Art arbeiten mit äußerst geringen Helium-Verlustraten in einer Größenordnung von 10 ml/h ("low loss"), wodurch sich Haltezeiten bis über ein Jahr erzielen lassen.

Die von diesen Kryostaten aufgenommenen NMR-Magnetspulen können Magnetfelder von 2 bis 15 Tesla und einer Stabilität von 10⁻⁸/h (maximale Felddrift) erzeugen. Die Homogenität derartiger Magnetfelder für die hochauflösende NMR-Spektroskopie beträgt derzeit zwischen 10⁻⁸ bis 10⁻¹⁰ bei Verwendung von Shimspulen im Raumtemperaturbereich, die zum Ausgleich von kleinen Feldfehlern des Hauptfeldmagneten dienen. Den höheren Homogenitätswert von ca. 10⁻¹⁰ erreicht man in der Praxis bei Meßproben mit ca. 5 mm Durchmesser und ca. 8 mm Länge.

Wie eingangs diskutiert, können sich durch ungleichmäßige Abkühlung der Stahlrohre 13, durch die flüssiger Stickstoff in den Behälter 7 eingeleitet, bzw. abdampfender Stickstoff daraus entfernt wird, mechanische Verspannungen durch unterschiedliche thermisch bedingte Kontraktionen der Stahlrohre 13 ergeben, die zu einem Verkippen bzw. zu einer horizontalen Verschiebung des Flüssigstickstoffbehälters 7 aus seiner ursprünglichen Lage führen. Eine derartige ungleichmäßige Abkühlung ist insbesondere deshalb zu erwarten, da an einem der drei Stahlrohre 13 aus Sicherheitsgründen ständig ein Überdruckventil vorgesehen sein muß, durch welches kein flüssiger Stickstoff fließt, so daß bereits in der Auffüllphase des Stickstoffbehälters 7 das betreffende Stahlrohr 13 wärmer ist als die beiden anderen.

Über die nach dem bekannten Stand der Technik mechanisch starr ausgeführten thermischen Verbindungselemente 6 zwischen dem Flüssigstickstoffbehälter 7 und den Heliumabdampfrohren 4 wird eine Kippbewegung oder seitliche Verschiebung des Flüssigstickstoffbehälters 7 mechanisch über die als Befestigungsmittel wirkenden Abdampfrohre 4 auf die mit flüssigem Helium gefüllten und die NMR-Magnetspule 2 enthaltenden Zentralbehälter 3 übertragen. Dies führt wiederum zu einer Verschiebung der Magnetspule 2 und damit des durch sie erzeugten Magnetfeldes relativ zu der in einer zentralen Zimmertemperaturbohrung 18 durch den Kryostaten 1 befindlichen, in der Zeichnung nicht dargestellten NMR-Meßprobe. Damit wird sowohl die oben erwähnte hohe Homogenität des NMR-Magnetfeldes als auch dessen zeitliche Stabilität beeinträchtigt, und es wird ein "Nachshimen" des Feldes erforderlich, sobald wieder ein definierter mechanischer Zustand der Geometrie der Kryostatenbestandteile erreicht ist.

Um eine solche relative Feldverschiebung zu vermeiden, werden erfindungsgemäß die Verbindungselemente 6 mechanisch flexibel gehalten, um mögliche Bewegungen des Flüssigstickstoffbehälters 7 von dem Zentralbehälter 3 und damit von der Magnetspule 2 mechanisch abzukoppeln.

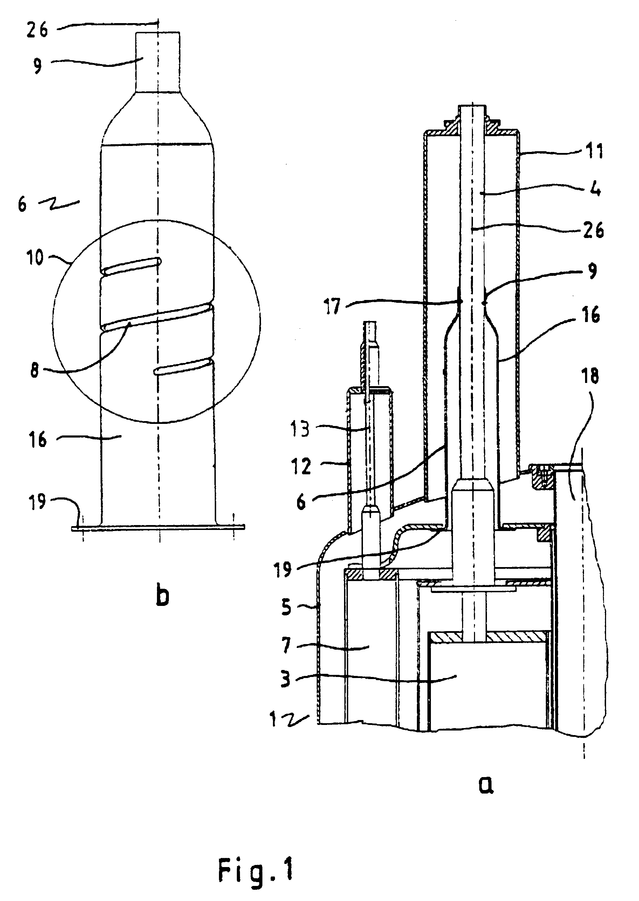

In Fig.1a ist ausschnittsweise ein Längsschnitt durch den Kryostaten 1 dargestellt, der einen Heliumabdampfturm 11 und einen Stickstoffabdampfturm 12 sowie die darin befindlichen Elemente zeigt. Wesentlich für die Erfindung ist insbesondere das mechanisch flexibel gestaltete rohrförmige Verbindungselement 6, das aus einem thermisch besonders gut leitfähigen Material, beispielsweise aus Kupfer bestehen kann.

In der in Fig. 1b gezeigten Ausführungsform erhält das Verbindungselement 6 seine Flexibilität durch einen spiralwendelförmigen Schlitz 8 am Umfang des Rohres 16. Wie in der Zeichnung angedeutet, erstreckt sich der Schlitz 8 lediglich in einem bestimmten begrenzten Bereich 10 der axialen Länge des Verbindungselementes 6, der vorzugsweise etwa in der Mitte zwischen den Rohrenden des Rohres 16 liegt. Nur in diesem Bereich 10 weist daher das Verbindungselement 6 die zur Lösung der Erfindungsaufgabe erforderliche mechanische Flexibilität auf. Diese reicht aber bereits aus, um die erwünschte mechanische Abkopplung der Bewegung des Stickstoffbehälters 7 vom Zentralbehälter 3 zu erreichen.

In Richtung seiner Längsachse 26 weist das in Fig. 1b dargestellte Verbindungselement 6 unterschiedliche Durchmesser auf. Insbesondere hat das Rohr 16 an der Kontaktstelle 17 mit dem Heliumabdampfrohr 4 einen engen Querschnitt, während es in axialem Abstand von der Kontaktstelle 17 abwärts radial weiter ist, um das Heliumabdampfrohr 4 nicht zu berühren und als Strahlungsschild wirken zu können.

Um eine besonders gute thermische Verbindung mit dem Heliumabdampfrohr 4 herstellen zu können, weist das Verbindungselement 6 an der Kontaktstelle 17 einen starren, das Heliumabdampfrohr 4 eng umschließenden ringförmigen Kragen 9 auf, der vorzugsweise aus Kupfer oder Aluminium besteht und Teil des sich an dieser Stelle verjüngenden Rohres 16 sein kann. Der Kragen 9 kann aber auch als eigenständiges Teil ausgeführt sein, wobei auf eine sehr gute thermische Verbindung zu dem Rohr 16, das den flexiblen Teil 10 des Verbindungselementes 6 trägt, geachtet werden muß.

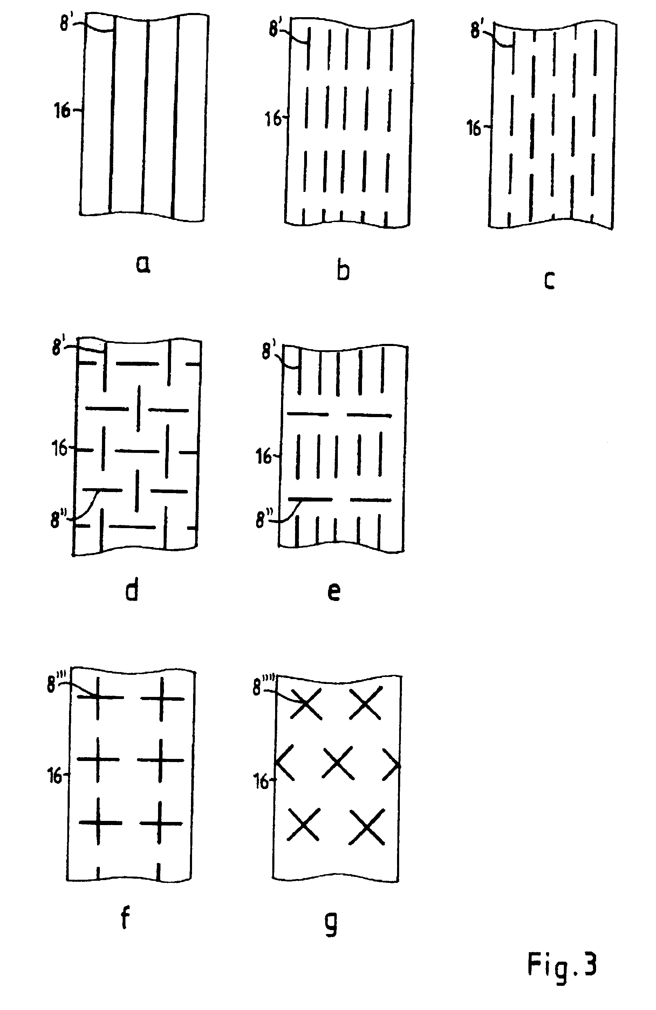

Statt der in Fig. 1b gezeigten Ausführungsform des Verbindungselementes 6 mit gewendeltem Schlitz 8 sind auch andere Schlitzformen möglich, wie in Fig. 3 schematisch angedeutet. Fig. 3a zeigt ein Verbindungselement 6 mit im wesentlichen parallel zur Längsachse 26 des Rohres 16 geführten Schlitzen 8'. Bei der Ausführungsform nach Fig. 3a sind die Schlitze im Verhältnis zur Rohrlänge relativ lang, um eine hohe Flexibilität des Verbindungselementes 6 in einer Richtung quer zur Längsachse 26 zu erreichen.

In Fig. 3b sind ebenfalls Längsschlitze 8' gezeigt, die jedoch eine im Verhältnis zur axialen Erstreckung des Rohres 16 geringe Länge aufweisen. Das gleiche gilt auch für die Schlitze 8' in der Ausführungsform nach Fig. 3c. In beiden Fällen ist sowohl in Umfangsrichtung nebeneinander als auch in axialer Richtung des Rohres 16 untereinander eine Vielzahl von Schlitzen 8' vorgesehen, um die aufgrund der geringeren Schlitzlänge geringere Flexibilität des Verbindungselementes 6 gegenüber der Ausführungsform nach Fig. 3a auszugleichen. Ein Vorteil der Ausführungsformen nach Fig. 3b und 3c besteht in der etwas höheren Wärmeleitfähigkeit der entsprechenden Rohre 16. Durch die unterschiedliche Anordnung der Längsschlitze 8' in den Ausführungsformen nach Fig. 3b und 3c können die mechanischen Eigenschaften, insbesondere die Reaktion auf Zug- und Verwindungskräfte des Rohres 16 unterschiedlich gestaltet werden.

Wie in Fig. 3d und 3e gezeigt, können die Rohre 16 außer den Längsschlitzen 8' auch Querschlitze 8'' in einer Richtung quer zur Längsachse 26 aufweisen, die eine Ausdehnung oder Stauchung der Rohre 16 in Richtung der Längsachse 26 erlauben. Die relative Anordnung von Längsschlitzen 8' und Querschlitzen 8'' kann ebenfalls unterschiedlich gewählt werden, wie in Fig. 3d und 3e gezeigt, um unterschiedliche mechanische Eigenschaften des jeweiligen Rohres 16 zu erzielen.

Schließlich können, wie in Fig. 3f gezeigt, auch kreuzförmige Schlitze 8''', und wie in Fig. 3g gezeigt X-förmige Schlitze 8'''' Verwendung finden. Daneben sind noch beliebig viele andere Schlitzgeometrien denkbar, die hier im einzelnen nicht vorgestellt werden können.

Bei einer in der Zeichnung nicht dargestellten Ausführungsform weisen die rohrförmigen Verbindungselemente 6 flexible Bänder auf, die beispielsweise aus geflochtenen Kupferfilamenten bestehen können. Vorzugsweise sind diese flexiblen Bänder am einen Ende des Verbindungselementes 6 mit einem starren Kragen 9 thermisch gut leitend verbunden, um einen möglichst guten Wärmeübergang zu den Befestigungsmitteln 4 herzustellen. Auch am anderen Ende, an dem das Verbindungselement 6 mit dem Flüssigstickstoffbehälter 7 in Kontakt steht, empfielt sich die Verwendung eines starren Kontaktkragens, der beispielsweise aus einem dem in Fig. 1a gezeigten, am Rohr 16 vorgesehenen Flansch 19 entsprechenden Teil bestehen kann. Der Vorteil dieser Ausführungsform des Verbindungselementes 6 mit flexiblen Bändern besteht in der dadurch möglichen totalen mechanischen Entkopplung des Zentralbehälters 3 von dem ihn schalenförmig umgebenden Flüssigstickstoffbehälter 7, da die flexiblen Bänder jegliche Relativbewegung durch ein Ausbauschen vollständig aufnehmen. Ein Nachteil dieser Ausführungsform besteht allerdings darin, daß die Funktion des Verbindungselementes 6 als Strahlungsschild beeinträchtigt wird.

### Ausführungsbeispiel:

Bei einem konkreten Ausführungsbeispiel beträgt der Außendurchmesser des Außenmantels 5 670 mm, der Stickstoffabdampfturm 12 liegt auf einem Teilkreis um die Mittelachse des Kryostaten 1 mit einem Durchmesser von 550 mm, der Heliumabdampfturm 11 liegt auf einem Teilkreis mit einem Durchmesser von 330 mm und hat eine Höhe von ungefähr 390 mm; die Höhe des Stahlrohres 13 gemessen vom oberen Ende des Flüssigstickstoffbehälters 7 beträgt 270 mm; der Abstand der Oberkante des Verbindungselementes 6 von der Oberseite des Flüssigstickstoffbehälters 7 beträgt 315 mm und der Abstand des Flansches 19 von der Oberseite des Flüssigstickstoffbehälters 7 beträgt 43 mm.

Das Verbindungselement 7, wie es im Ausführungsbeispiel nach Fig. 1b gezeigt ist, kann aus einem nach oben hin verengten Rohr der Gesamthöhe von 275 mm und einem maximalen Außendurchmesser von 60 mm bestehen, wobei der gezeigte spiralwendelförmige Schlitz 8 eine axiale Ausdehnung von 82 mm und eine Schlitzbreite von 4 mm aufweist.

Der Kryostat 1 im Ausführungsbeispiel besitzt drei gleich lange Stahlrohre 13 zum Abdampfen von flüssigem Stickstoff, die an ihrer Unterseite eine Temperatur von 77 K aufweisen. An ihrer Oberseite können die Temperaturen unterschiedlich sein: Bei dem mit einem Sicherheitsventil versehenen Stickstoffabdampfrohr liegt die Temperatur der Oberseite auf Umgebungstemperatur (ungefähr 290 K), während sie bei den anderen Rohren etwa 210 K betragen kann. Der Temperaturverlauf der Stahlrohre 13 sollte in jedem Fall linear sein. Der Längenunterschied zwischen einem Stahlrohr 13 mit Ventil gegenüber den beiden anderen Stahlrohren ohne Ventil beträgt dann ca. 0,17 mm. Unter der Annahme, daß das Heliumgefäß 3 samt seinen beiden zugehörigen Abdampfrohren 4 nicht vorhanden wäre, würde der Ort der Kontaktstelle 17 eine horizontale Verschiebung von ca. 0,11 mm erfahren. Bei vorhandenem Heliumbehälter dürfte dieser Wert etwas kleiner sein. Diese Angaben beruhen allerdings lediglich auf einer groben Abschätzung, da eine exakte Berechnung der tatsächlichen horizontalen Verschiebungen extrem aufwendig wäre.

Der Verschiebungswert von 0,11 mm mag zunächst sehr gering erscheinen. Man muß dabei jedoch beachten, daß in der hochauflösenden NMR-Spektroskopie wie bereits oben erwähnt Feldhomogenitäten von 10⁻⁹ bis 10⁻¹⁰ erforderlich sind. Der Kryomagnet selbst liefert eine Feldhomogenität von 10⁻⁶ bis 10⁻⁷ innerhalb eines Probengläschens von 5 mm Durchmesser. Die verbleibenden drei Größenordnungen müssen durch ein Raumtemperatur-Shim erreicht werden. Die resultierende Homogenität muß also einerseits sehr hoch sein und ist aber andererseits von zwei Systemen abhängig, die nicht starr miteinander verbunden werden können. Diese beiden Tatsachen führen zusammen zu dem Problem, daß bereits kleinste relative Verschiebungen zwischen Magnetsystem und Shimsystem nicht-tolerierbare Feldinhomogenitäten verursachen. Die vorliegende Erfindung bietet eine Lösung für dieses Problem.

## Patentansprüche

1. Kryostat zur Aufnahme einer supraleitenden Magnetspule, beispielsweise für Kernspinresonanz (NMR) - oder Ionenzyklotronresonanz (ICR)-Messungen, mit einem Zentralbehälter für eine kryogene Flüssigkeit, insbesondere flüssiges Helium, der durch Befestigungsmittel, vorzugsweise dünnwandige Aufhängungsrohre, mit der Innenseite eines geschlossenen Außenmantels des Kryostaten mechanisch verbunden, vorzugsweise daran angehängt ist, wobei die Befestigungsmittel über thermisch gut leitfähige, rohrförmige Verbindungselemente, die die Befestigungsmittel allseitig umgeben, in gutem thermischen Kontakt mit einer den Zentralbehälter umgebenden Schale stehen, die auf der Temperatur einer zweiten kryogenen Flüssigkeit, insbesondere flüssigen Stickstoffs, deren Siedepunkt höher als der Siedepunkt der Flüssigkeit im Zentralbehälter liegt, gehalten wird,
dadurch gekennzeichnet,
daß die thermisch gut leitfähigen, rohrförmigen Verbindungselemente (6) mechanisch flexibel gestaltet sind.

2. Kryostat nach Anspruch 1, dadurch gekennzeichnet, daß die Verbindungselemente (6) Rohre (16) aus einem thermisch gut leitfähigen Material, beispielsweise aus Kupfer mit vorzugsweise zylindrischem Querschnitt, sind, die am Umfang mit Schlitzen (8, 8', 8'', 8''', 8'''') versehen sind.

3. Kryostat nach Anspruch 2, dadurch gekennzeichnet, daß die Schlitze (8) spiralwendelförmig am Umfang der Rohre (16) vorgesehen sind.

4. Kryostat nach Anspruch 2, dadurch gekennzeichnet, daß die Schlitze (8') i.w. parallel zur Längsachse (26) vorgesehen sind.

5. Kryostat nach Anspruch 4, dadurch gekennzeichnet, daß die Schlitze (8') mindestens eine der halben axialen Erstreckung der Rohre (16) entsprechende Länge aufweisen.

6. Kryostat nach Anspruch 4, dadurch gekennzeichnet, daß die Schlitze (8') eine im Verhältnis zur axialen Erstreckung der Rohre (16) geringe Länge aufweisen.

7. Kryostat nach Anspruch 6, dadurch gekennzeichnet, daß sowohl in Umfangsrichtung nebeneinander als auch in axialer Richtung übereinander eine Vielzahl von Schlitzen (8') vorgesehen ist.

8. Kryostat nach einem der Ansprüche 4 bis 7, dadurch gekennzeichnet, daß auch Schlitze (8'') in einer Richtung quer zur Längsachse (26) der Rohre (16) vorgesehen sind.

9. Kryostat nach einem der Ansprüche 2 bis 8, dadurch gekennzeichnet, daß kreuzförmige und/oder X-förmige Schlitze (8''' bis 8'''') vorgesehen sind.

10. Kryostat nach einem der vorhergehenden Ansprüche, dadurch gekennzeichnet, daß die rohrförmigen Verbindungselemente (6) flexible Bänder, insbesondere zu Bändern geflochtene Filamente, beispielsweise Kupfer-Filamente aufweisen.

11. Kryostat, nach einem der vorhergehenden Ansprüche, dadurch gekennzeichnet, daß die rohrförmigen Verbindungselemente (6) nur in einem bestimmten Bereich (10) ihrer axialen Länge flexibel sind, vorzugsweise im mittleren Bereich (10) zwischen den Rohrenden.

12. Kryostat nach einem der vorhergehenden Ansprüche, dadurch gekennzeichnet, daß die rohrförmigen Verbindungselemente (6) auf ihrer axialen Länge unterschiedliche Durchmesser aufweisen.

13. Kryostat nach Anspruch 12, dadurch gekennzeichnet, daß die rohrförmigen Verbindungselemente (6) an dem Ende, an dem sie mit den Befestigungsmitteln (4) in thermischem Kontakt stehen, einen engen Querschnitt aufweisen, während sie in axialem Abstand von der Kontaktstelle (17) radial weiter sind.

14. Kryostat nach einem der vorhergehenden Ansprüche, dadurch gekennzeichnet, daß die rohrförmigen Verbindungselemente (6) an der Kontaktstelle (17) mit den Befestigungsmitteln (4) einen starren, die Befestigungsmittel (4) eng umschließenden ringförmigen Kragen (9) aufweisen, der vorzugsweise aus Kupfer oder Aluminium besteht, und an den die übrigen Teile der Verbindungselemente (6), insbesondere der flexible Teil (10), thermisch gut leitend angeschlossen sind.

15. Kryostat nach einem der vorhergehenden Ansprüche, dadurch gekennzeichnet, daß die rohrförmigen Verbindungselemente (6) die Befestigungsmittel (4) außerhalb der Kontaktstelle (17) über eine axiale Länge in Richtung von der Kontaktstelle (17) zum Zentralbehälter (3) berührungsfrei vollständig umgeben.

## Claims

1. Cryostat for the acceptance of a superconducting magnet coil, for example, for nuclear magnetic resonance (NMR) or ion cyclotron resonance (ICR) measurements with a central vessel for a cryogenic fluid, in particular fluid helium, which with a holding means, preferentially thin-walled suspension tubes, is mechanically connected to, preferentially suspended from, the inner side of a closed outer jacket of the cryostat, whereby the holding means are, via good thermally conducting tube-shaped connecting elements which surround the holding means on all sides, in good thermal contact with a shell which surrounds the central vessel, the shell being maintained at the temperature of a second cryogenic liquid, in particular liquid nitrogen, whose boiling temperature is higher than the boiling temperature of the fluid in the central vessel,
characterized in that
the good thermally conducting tube-shaped elements (6) are configured to be mechanically flexible.

2. Cryostat according to claim 1 characterized in that the connecting elements (6) are tubes (16) made from a thermally good conducting material, for example, from copper with preferentially cylindrical cross-section, which are provided with slits around their circumference (8, 8', 8", 8'", 8"").

3. Cryostat according to claim 2 characterized in that the slits (8) have spiral helix shapes around the circumference of the tubes (16).

4. Cryostat according to claim 2 characterized in that the slits (8') are provided to be largely parallel to the longitudinal axis (26).

5. Cryostat according to claim 4 characterized in that the slits (8') exhibit a length which is at least half the axial extent of the tubes (16).

6. Cryostat according to claim 4 characterized in that the slits (8') exhibit a length which is relatively small compared to the axial extent of the tubes (16).

7. Cryostat according to claim 6 characterized in that a plurality of slits (8') are provided for next to another in a circumference direction as well as above each other in the axial direction.

8. Cryostat according to one of the claims 4 to 7 characterized in that slits (8") are also provided for in a direction transverse to the longitudinal axis (26) of the tubes (16).

9. Cryostat according to one of the claims 2 to 8 characterized in that cross-shaped and/or X-shaped slits (8"' through 8"") are provided for.

10. Cryostat according to one of the preceding claims characterized in that the tube-shaped connecting elements (6) exhibit flexible bands, in particular bands woven from filaments, for example, copper filaments.

11. Cryostat according to one of the previous claims characterized in that the tube-shaped connecting elements (6) are flexible only over a particular region (10) of their axial length, preferentially in the middle region (10) between the tube ends.

12. Cryostat according to one of the previous claims characterized in that the tube-shaped connecting elements (6) exhibit varying diameters along their axial length.

13. Cryostat according to claim 12 characterized in that the tube-shaped connecting elements (6), at the end at which they are in thermal contact with the holding means (4), exhibit a narrow cross-section whereas at an axial separation from the contact location (17), are radially widened.

14. Cryostat according to one of the previous claims characterized in that the tube-shaped connecting elements (6) at the contact location (17) to the holding means (4) exhibit a rigid ring-shaped collar (9) which tightly surrounds the holding means (4), the collar preferentially comprising copper or aluminium and being in good thermal contact with the remaining portions of the connecting elements (6), in particular, the flexible portion (10).

15. Cryostat according to one of the previous claims characterized in that the tube-shaped connecting elements (6) completely enclose, without touching, the holding means (4) outside of the contact location (17) over an axial length in the direction extending from the contact location (17) towards the central vessel (3).

## Revendications

1. Cryostat destiné à recevoir une bobine magnétique supraconductrice, par exemple pour des mesures de résonance magnétique nucléaire ou de résonance cyclotron ionique, comprenant un réservoir central qui est destiné à un liquide cryogénique, et en particulier à de l'hélium liquide, et qui est relié mécaniquement, et de préférence suspendu, au côté intérieur d'une surface latérale extérieure fermée du cryostat grâce à des moyens de fixation, et de préférence à des tubes de suspension à paroi mince, cependant que, par l'intermédiaire d'éléments de liaison tubulaires bons conducteurs de la chaleur qui entourent les moyens de fixation de tous les côtés, les moyens de fixation présentent un bon contact thermique avec une enceinte qui entoure le réservoir central et qui est maintenue à la température d'un deuxième liquide cryogénique, et en particulier de l'azote liquide, dont le point d'ébullition est plus élevé que le point d'ébullition du liquide contenu dans le réservoir central, caractérisé par le fait que les éléments de liaison tubulaires bons conducteurs de la chaleur (6) sont mécaniquement flexibles.

2. Cryostat selon la revendication 1, caractérisé par le fait que les éléments de liaison (6) sont des tubes (16) en une matière bonne conductrice de la chaleur, et par exemple en cuivre avec une section transversale de préférence circulaire, qui sont pourvus de fentes (8, 8', 8", 8"', 8"") sur le pourtour.

3. Cryostat selon la revendication 2, caractérisé par le fait que les fentes (8) sont prévues en forme de spirales sur le pourtour des tubes (16).

4. Cryostat selon la revendication 2, caractérisé par le fait que les fentes (8') sont prévues en étant pour l'essentiel parallèles à l'axe longitudinal (26).

5. Cryostat selon la revendication 4, caractérisé par le fait que les fentes (8') présentent au moins une longueur qui correspond à la moitié de l'étendue des tubes (16) dans le sens axial.

6. Cryostat selon la revendication 4, caractérisé par le fait que les fentes (8') présentent une longueur qui est inférieure à l'étendue des tubes (16) dans le sens axial.

7. Cryostat selon la revendication 6, caractérisé par le fait qu'il est prévu une pluralité de fentes (8') qui sont aussi bien juxtaposées dans la direction du pourtour que superposées dans la direction axiale.

8. Cryostat selon l'une des revendications 4 à 7, caractérisé par le fait qu'il est également prévu des fentes (8") dans une direction qui est transversale par rapport à l'axe longitudinal (26) des tubes (16).

9. Cryostat selon l'une des revendications 2 à 8, caractérisé par le fait qu'il est prévu des fentes en forme de croix et/ou en forme de X (8"' et 8"").

10. Cryostat selon l'une des revendications précédenttes, caractérisé par le fait que les éléments de liaison tubulaires (6) comportent des bandes flexibles, et en particulier des filaments, comme par exemple des filaments en cuivre, qui sont en particulier tressés pour donner des bandes.

11. Cryostat selon l'une des revendications précédenttes, caractérisé par le fait que les éléments de liaison tubulaires (6) ne sont flexibles que dans une zone déterminée (10) de leur longueur dans le sens axial, et de préférence dans leur zone centrale (10) entre les extrémités des tubes.

12. Cryostat selon l'une des revendications précédenttes, caractérisé par le fait que les éléments de liaison tubulaires (6) présentent des diamètres différents sur leur longueur dans le sens axial.

13. Cryostat selon la revendication 12, caractérisé par le fait que les éléments de liaison tubulaires (6) présentent une section transversale étroite à leur extrémité par laquelle ils sont en contact thermique avec les moyens de fixation (4), tandis qu'ils sont plus larges dans le sens radial à une distance dans le sens axial de l'endroit (17) du contact.

14. Cryostat selon l'une des revendications précédenttes, caractérisé par le fait que les éléments de liaison tubulaires (6) présentent, à l'endroit (17) du contact avec les moyens de fixation (4), un collet annulaire rigide (9) qui entoure étroitement les moyens de fixation (4), qui est de préférence en cuivre ou en aluminium et auquel les autres parties des éléments de liaison (6), et en particulier la partie flexible (10), sont raccordées avec une bonne conduction de la chaleur.

15. Cryostat selon l'une des revendications précédenttes, caractérisé par le fait que les éléments de liaison tubulaires (6) entourent complètement et sans contact les moyens de fixation (4) à l'extérieur de l'endroit (17) du contact sur une certaine longueur dans le sens axial dans la direction allant de l'endroit (17) du contact vers le réservoir central (3).
